# EUROPÄISCHE PATENTSCHRIFT

(11) **EP 2 195 671 B1**
(45) Veröffentlichungstag und Bekanntmachung des Hinweises auf die Patenterteilung: **12.01.2011**
(21) Anmeldenummer: 08838310.4
(22) Anmeldetag: 25.09.2008
(51) Int. Cl.: G01R 31/28

(54) **HANDHABUNGSVORRICHTUNG FÜR ELEKTRONISCHE BAUELEMENTE, INSBESONDERE IC'S, MIT PNEUMATIKZYLINDERBEWEGUNGSEINRICHTUNG ZUM VERSCHIEBEN VON PLUNGERN**
HANDLER FOR ELECTRONIC COMPONENTS, IN PARTICULAR IC'S, COMPRISING A PNEUMATIC CYLINDER DISPLACEMENT UNIT FOR MOVING PLUNGERS
DISPOSITIF DE MANIPULATION POUR COMPOSANTS ÉLECTRONIQUES, NOTAMMENT POUR CIRCUITS INTÉGRÉS, POURVU D'UN DISPOSITIF DE MISE EN MOUVEMENT DE VÉRINS PNEUMATIQUES DESTINÉ À FAIRE COULISSER DES PISTONS PLONGEURS

(30) Priorität: 05.10.2007 DE 102007047678
(43) Veröffentlichungstag der Anmeldung: 16.06.2010
(73) Patentinhaber: Multitest elektronische Systeme GmbH, 83026 Rosenheim (DE)
(72) Erfinder: THIEL, Stefan, D-83022 Rosenheim (DE); JESERER, Günther, D-83104 Tuntenhausen (DE); WIESBÖCK, Andreas, D-83071 Stephanskirchen (DE); BAUER, Alexander, D-83026 Rosenheim (DE)
(74) Vertreter: Bauer, Friedrich
(86) Internationale Anmeldenummer: PCT/EP2008/008152
(87) Internationale Veröffentlichungsnummer: WO 2009/046882

(56) Entgegenhaltungen:
- EP-A- 1 832 886
- WO-A-2006/059553
- WO-A-2006/114836
- US-A- 5 469 953
- US-A- 5 957 305
- US-A- 6 031 384
- US-A1- 2003 147 736
- US-B1- 6 209 194

## Beschreibung

Die Erfindung betrifft eine Handhabungsvorrichtung für elektronische Bauelemente, insbesondere IC's, mit mindestens einer Transporteinheit zum Transportieren von zu testenden Bauelementen in eine Position, in der die Bauelemente Kontakteinrichtungen einer Testvorrichtung gegenüberliegen, und mit einer von der Transporteinheit getrennten Vorschubeinrichtung zum Verschieben von Plungern, die auf der Transporteinheit angeordnet und zum Halten der Bauelemente ausgebildet sind, gemäß dem Oberbegriff des Anspruches 1.

Elektronische Bauelemente, wie beispielsweise IC's (Halbleiterbauelemente mit integrierten Schaltungen), werden üblicherweise auf ihre Funktionsfähigkeit hin überprüft, bevor sie beispielsweise auf Leiterplatten montiert oder anderweitig verwendet werden. Die zu testenden Bauelemente werden hierbei von einem üblicherweise als "Handler" bezeichneten Handhabungsautomaten mit Kontakteinrichtungen kontaktiert, die insbesondere als Kontaktsockeln ausgebildet sind und mit einem Testkopf einer Testvorrichtung in elektrischem Kontakt stehen. Nach Beendigung des Testvorgangs werden die Bauelemente mittels des Handlers wieder von den Kontakteinrichtungen entfernt und in Abhängigkeit des Testergebnisses sortiert.

Eine Handhabungsvorrichtung gemäß dem Oberbegriff des Anspruchs 1 ist aus der US 5 469 953 bekannt.

Zum Halten und Kontaktieren der Bauelemente weist diese Handhabungsvorrichtung Plunger auf, d.h. längsverschiebbare Halteeinheiten, welche von stationären rückseitigen Pneumatikzylindern mit ausfahrbaren Kolbenstangen in Ricktung der Bauelemente verschoben werden können, um die Bauelemente zu kontaktieren und mittels Saugkraßt zu halten. Die Plunger werden nach dem Ansaugen der Bauelemente innerhalb des Handlers in eine Position gebracht, in der sie auf geradlinigem Weg weiter zu den Kontakteinrichtungen vorgeschoben werden können, bis die Bauelemente mit den Kontakteinrichtungen in Kontakt gelangen. Nach Durchführung der Testvorgänge werden die Bauelemente mittels der Plunger wieder vom Testkopf entfernt und derart positioniert, dass sie über eine Entladestation aus dem Handler entfernt und in Abhängigkeit des Testergebnisses sortiert werden können.

Um den Testvorgang der Bauelemente auf möglichst wirtschaftliche Weise durchführen zu können, ist es von entscheidender Bedeutung, dass die Handler mit sehr hohen Geschwindigkeiten arbeiten, d.h. dass möglichst hohe Durchsätze erzielt werden.

Zu diesem Zweck ist bereits eine Handlerzentraleinheit mit einem quaderförmigen Zentralteil bekannt, an dem eine Mehrzahl von Plungern längsverschiebbar geführt ist, die an ihrem vorderen Ende die Bauelemente mittels Vakuum halten. Das Schieben der Plunger erfolgt dort mittels einer Vorschubeinrichtung in der Form von Pneumatikzylindern. Obwohl sich dieses Prinzip bewährt hat, ist es schwierig oder mit hohem Aufwand verbunden, auf diese Weise eine Vielzahl von Plungern der Transporteinheit in kürzester Zeit und auf sehr präzise Weise bis in die vordere Kontaktposition zu bringen und dabei gleichzeitig eine weiche, schonende Kontaktierung der Bauelemente sicherzustellen.

Der Erfindung liegt die Aufgabe zugrunde, eine Handhabungsvorrichtung der eingangs genannten Art mit einer Vorschubeinrichtung zu schaffen, mit der auch eine Mehrzahl von Plungern, an denen die zu testenden Bauelemente gehalten sind, auf relativ einfache, schnelle und präzise Weise in die vordere Testposition überführt werden können und eine schonende Kontaktierung der Bauelemente erreicht werden kann.

Diese Aufgabe wird erfindungsgemäß durch eine Handhabungsvorrichtung mit den Merkmalen des Anspruches 1 gelöst. Vorteilhafte Ausführungsformen der Erfindung sind in den weiteren Ansprüchen beschrieben.

Bei der erfindungsgemäßen Handhabungsvorrichtung ist die Pneumatikzylindereinrichtung verschiebbar ausgebildet und mit einer die Pneumatikzylindereinrichtung in Axialrichtung der Plunger hin- und herbewegenden Pneumatikzylinderbewegungseinrichtung gekoppelt.

Erfindungsgemäß besteht somit die Vorschubeinrichtung zum Verschieben der Plunger aus einer Kombination einer verschiebbar angeordneten Pneumatikzylindereinrichtung und einer die Pneumatikzylindereinrichtung in Axialrichtung der Plunger hin- und herbewegenden Pneumatikzylinderbewegungseinrichtung. Dadurch, dass die Pneumatikzylinder als ganzes von der Pneumatikzylinderbewegungseinrichtung hin-und herbewegt werden, kann die Pneumatikzylinderbewegungseinrichtung gezielt dahingehend ausgebildet und optimiert werden, dass der erforderliche Zustellweg auf sehr schnelle Weise überbrückt werden kann, während die Pneumatikzylinder als Federelemente wirken, die ein weiches Aufsetzen der Anschlusskontakte des Bauelements auf den Kontakteinrichtungen (Kontaktsockeln) sicherstellen. Hierdurch kann einerseits eine sehr schnelle und andererseits auch weiche, sanfte Kontaktierung erreicht werden, was insbesondere die an den Kontakteinrichtungen vorhandenen Anschlusskontakte, beispielsweise Kontaktfedern, schont. Weiterhin ergibt sich durch den Weg, den die Pneumatikzylinder mit ihrem Hub ausgleichen können, die Möglichkeit, Toleranzen bei der Kontaktierung auszugleichen. Alle Bauelemente werden mit dem gleichen Druck gegen die Kontakteinrichtungen gedrückt.

Gemäß einer vorteilhaften Ausführungsform besteht die Pneumatikzylinderbewegungseinrichtung aus einer Kurbelwelleneinrichtung, die eine Antriebseinrichtung, eine von der Antriebseinrichtung in Umdrehung versetzbare Kurbelwelle und mindestens eine exzentrisch an der Kurbelwelle gelagerte Kurbelstange aufweist, die mit der Pneumatikzylindereinrichtung gekoppelt ist, um diese in Axialrichtung der Plunger zu verschieben. Eine derartige Kurbelwelleneinrichtung bietet den Vorteil, dass mittels dieser die Plunger, an denen die Bauelemente gehalten werden, auf relativ einfache, sehr schnelle und präzise Weise von ihrer zurückgezogenen Position in ihre vordere Kontaktposition überführt werden können. Von besonderem Vorteil ist dabei, dass die Kurbelwelleneinrichtung eine geschwindigkeitsabhängige Zustellung der Plunger ermöglicht, wobei die Zustellgeschwindigkeit von der Winkelposition der Kurbelwelle abhängt. Zweckmäßigerweise wird die Kurbelstange dabei so an der Kurbelwelle gelagert, dass die Zustellgeschwindigkeit bei Annäherung an die vordere Kontaktposition (Endposition) zunehmend niedriger wird, während die Zustellgeschwindigkeit zumindest über den größeren Teil des übrigen Zustellwegs sehr hoch sein kann. Auf diese Weise können kurze Zustellzeiten bei gleichzeitig sanfter Kontaktierung der Bauelemente mit den Kontaktiereinrichtungen (z.B. Kontaktsockeln) erzielt werden.

Die Pneumatikzylinderbewegungseinrichtung kann auch aus einer anderen Bewegungseinrichtung bestehen. Beispielsweise ist es möglich, hierfür einen Spindelantrieb vorzusehen. Weiterhin ist es auch denkbar, die Pneumatikzylindereinrichtung ebenfalls auf pneumatische Weise, beispielsweise mittels eines zentralen vorschubzlyinders, hin- und her zu bewegen.

Gemäß einer vorteilhaften Ausführungsform weist die Pneumatikzylindereinrichtung einen Plattenträger und eine an diesem befestigte Zylinderhalteplatte auf, wobei der Plattenträger verschiebbar an einer stationär innerhalb der Handhabungsvorrichtung angeordneten Führungseinrichtung geführt ist und die Pneumatikzylinder an der Zylinderhalteplatte befestigt sind. Dies ermöglicht eine sehr präzise Führung der Pneumatikzylindereinrichtung in Zustellrichtung und erleichtert darüber hinaus die Montage, da die Pneumatikzylinder vorab auf der Zylinderhalteplatte montiert werden können.

Gemäß einer vorteilhaften Ausführungsform ist jedem Plunger einer Transporteinheit ein Pneumatikzylinder zugeordnet. Hierdurch kann jedes Bauelement beim Kontaktieren unabhängig von anderen Bauelementen abgefedert werden.

Gemäß einer vorteilhaften Ausführungsform ist für jeden Pneumatikzylinder oder für einzelne Untergruppen von Pneumatikzylindern ein Steuerventil zum Öffnen bzw. Schließen zugeordneter Pneumatikleitungen vorgesehen, so dass jeder Pneumatikzylinder oder Untergruppen von Pneumatikzylindern individuell über die Steuerventile aktivierbar und nur ausgewählte Plunger in die vordere Testposition überführbar sind. Auf diese Weise besteht die Möglichkeit des "Disabling". Fallen z.B. testerseitig verschiedene Kontaktiereinrichtungen aus oder sollen nicht alle Kontaktiereinrichtungen bedient werden, so können einzelne Pneumatikzylinder eingezogen werden, wodurch die entsprechenden Plunger nicht in die vordere Kontaktposition überführt werden.

Gemäß einer vorteilhaften Ausführungsform sind die Pneumatikzylinder als Kurzhubzlyinder ausgebildet und weisen Kolbenstangen auf, die durch Luftdruck nachgiebig im Zylindergehäuse gehalten sind, wobei die Kraft zum Einschieben der Kolbenstangen zumindest über einen anfänglichen Teil des Einschubwegs im Wesentlichen konstant bleibt. Hierdurch ist es auf besonders präzise Weise möglich, die Bauelemente auch dann, wenn sie oder die Kontakteinrichtungen (Kontaktsockel) größere Maß- oder Lagetoleranzen aufweisen, auf einheitliche Weise mit dem gewünschten Druck an die Kontakteinrichtungen anzudrücken.

Die Erfindung wird nachfolgend beispielhaft anhand der Zeichnungen näher erläutert. Es zeigen:
- Figur 1 :: eine schematische Darstellung der erfin- dungsgemäßen Handhabungsvorrichtung und um- gebender Vorrichtungen bzw. Module, die beim Testen elektronischer Bauelemente verwendet werden,
- Figur 2 :: eine perspektivische Darstellung einer Hand- habungsvorrichtung mit drei teilweise dar- gestellten Umlaufwagen, wobei jedoch die Vorschubeinrichtung nicht eingezeichnet ist,
- Figur 3 :: eine schematische Seitenansicht der Handha- bungsvorrichtung von Figur 2 mit den drei Umlaufwagen und der erfindungsgemäßen Vor- schubeinrichtung,
- Figur 4 :: eine teilweise schräg geschnittene Darstel- lung eines Umlaufwagens von Figur 3, wobei vier Plunger für die Bauelemente dargestellt sind,
- Figur 5 :: eine schematische Seitenansicht der erfin- dungsgemäßen Vorschubeinrichtung,
- Figur 6 :: eine schematische Seitenansicht der Vorschu- beinrichtung von Figur 5 und von Kontaktier- einrichtungen, wobei sich die Vorschubein- richtung in der zurückgezogenen Position befindet,
- Figur 7 :: eine Darstellung entsprechend Figur 6, wobei sich die Vorschubeinrichtung in der vorge- schobenen Kontaktposition befindet,
- Figur 8 :: eine perspektivische Darstellung eines Teils der Vorschubeinrichtung in der zurückgezoge- nen Stellung,
- Figur 9 :: eine perspektivische Darstellung der Vor- schubeinrichtung von Figur 8 in der vorderen Kontaktposition,
- Figur 10 :: eine perspektivische Darstellung von Teilen der Handhabungsvorrichtung, der Vorschubein- richtung, der Transporteinheit und der Kon- taktiereinrichtungen von der Seite der Test- vorrichtung her, und
- Figur 11 :: einen Pneumatikschaltplan zur Versorgung von acht Pneumatikzylindern.

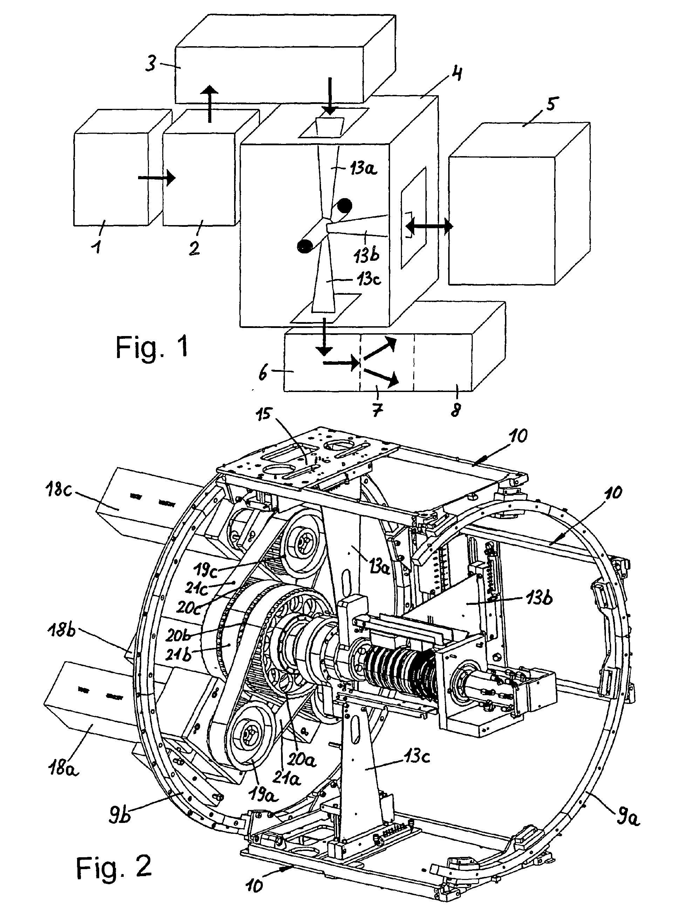

Anhand von Figur 1 wird zunächst schematisch und beispielhaft eine Anlage zum Testen elektronischer Bauelemente in Form von IC's (Halbleiterbauelemente mit integrierten Schaltungen) beschrieben. Die Pfeile geben dabei den Weg der Bauelemente an.

Die Bauelemente werden zunächst einer Ladeeinheit 1 zugeführt. Die Ladeeinheit 1 transportiert die Bauelemente zunächst zu einer Temperierkammer 2, um sie innerhalb der Temperierkammer 2 auf eine vorbestimmte Temperatur zu temperieren. Diese kann beispielsweise zwischen -60°C und +200°C liegen. Die Temperierung kann dabei auf konvektive und/oder konduktive Weise erfolgen. Nachdem die zu testenden Bauelemente in der Temperierkammer 2 auf die gewünschte Temperatur gebracht worden sind, werden sie von einer Transportvorrichtung 3, die beispielsweise eine Pick and Place-Einheit sein kann, aus der Temperierkammer 2 entnommen und einer Handhabungsvorrichtung 4 zugeführt. Die Handhabungsvorrichtung 4 enthält die notwendigen Einrichtungen zum Aufnehmen und Halten der Bauelemente, gegebenenfalls eine zusätzliche Temperierung der Bauelemente und eine Bauelementbewegungseinrichtung, um die Bauelemente einem Testkopf 5 zuzuführen und nach Beendigung des Testvorgangs wieder vom Testkopf 5 zu entfernen. Weiterhin kann die Handhabungsvorrichtung 4 bestimmte Einrichtungen enthalten, um auf die zu testenden Bauelemente in bestimmter Art und Weise einzuwirken, beispielsweise mit Beschleunigungen, Druck oder Neigung der Bauelemente.

Der Testkopf 5 wird in bekannter Weise an die Handhabungsvorrichtung 4 angedockt. Der Testkopf 5 ist Teil einer elektronischen Testvorrichtung, mit der die Bauelemente getestet und die Testergebnisse ausgewertet werden.

Nach Beendigung des Tests werden die Bauelemente von der Handhabungsvorrichtung 4 wieder vom Testkopf 5 entfernt und mittels einer Entnahmeeinheit 6 (Unloader oder Pick and Place-Einheit) einer Sortiereinheit 7 zugeführt. In der Sortiereinheit 7 werden die Bauelemente in Abhängigkeit des Testergebnisses sortiert. Anschließend gelangen die Bauelemente zu einer Entladestation 8.

Die außerhalb der Handhabungsvorrichtung 4 angeordnete Temperierkammer 2 ist lediglich optional. Falls die zu testenden Bauelemente nicht temperiert werden müssen, kann auf eine derartige Temperierkammer 2 verzichtet werden. Weiterhin ist es auch möglich, zusätzlich oder alternativ zur Temperierkammer 2 die Temperierung der zu testenden Bauelemente innerhalb der Handhabungsvorrichtung 4 vorzunehmen. Weiterhin muss die Zuführung der Bauelemente zur Handhabungsvorrichtung 4 nicht über die Transportvorrichtung 3 in Form einer Pick and Place-Einheit erfolgen, sondern kann auch, wie dem Fachmann bekannt ist, über Schwerkraft erfolgen. In diesem Fall handelt es sich um einen sogenannten Gravity Handler.

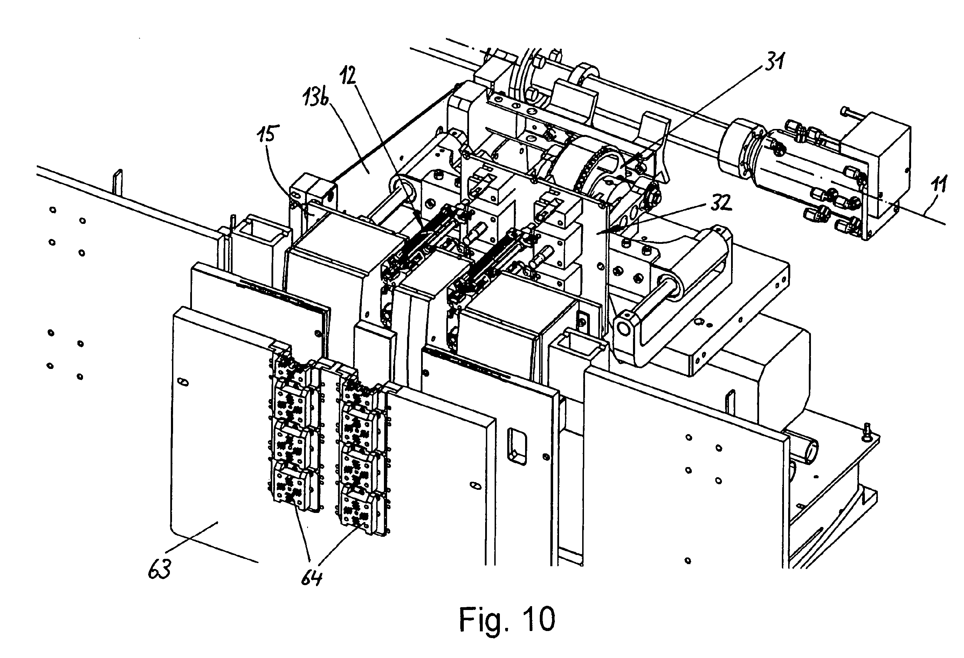

Anhand der Figuren 2 bis 11 werden im Folgenden Aufbau und Funktionsweise der erfindungsgemäßen Handhabungsvorrichtung 4 näher beschrieben.

Wie aus Figur 2 ersichtlich, weist die Handhabungsvorrichtung 4 eine Führungseinrichtung 9 mit zwei kreisringförmigen, stationären Führungen 9a, 9b auf, an denen drei Transporteinheiten in der Form von Umlaufwagen 10 verschiebbar gelagert sind. Die Führungen 9a, 9b erstrecken sich um eine gemeinsame Mittelachse 11 herum. Die Umlaufwagen 10 können längs der Führungen 9a, 9b auf einer Kreisbahn um die horizontale Mittelachse 11 herum unabhängig voneinander geführt werden, d.h. der Abstand eines jeden Umlaufwagens 10 zu einem vorauseilenden und nachfolgenden Umlaufwagen 10 kann in Umlaufrichtung variiert werden. Je nach Einsatzzweck der Handhabungsvorrichtung 4 kann die Anzahl der Umlaufwagen 10 variieren. Beispielsweise ist es möglich, zwei bis acht, insbesondere drei bis fünf, Umlaufwagen 10 vorzusehen.

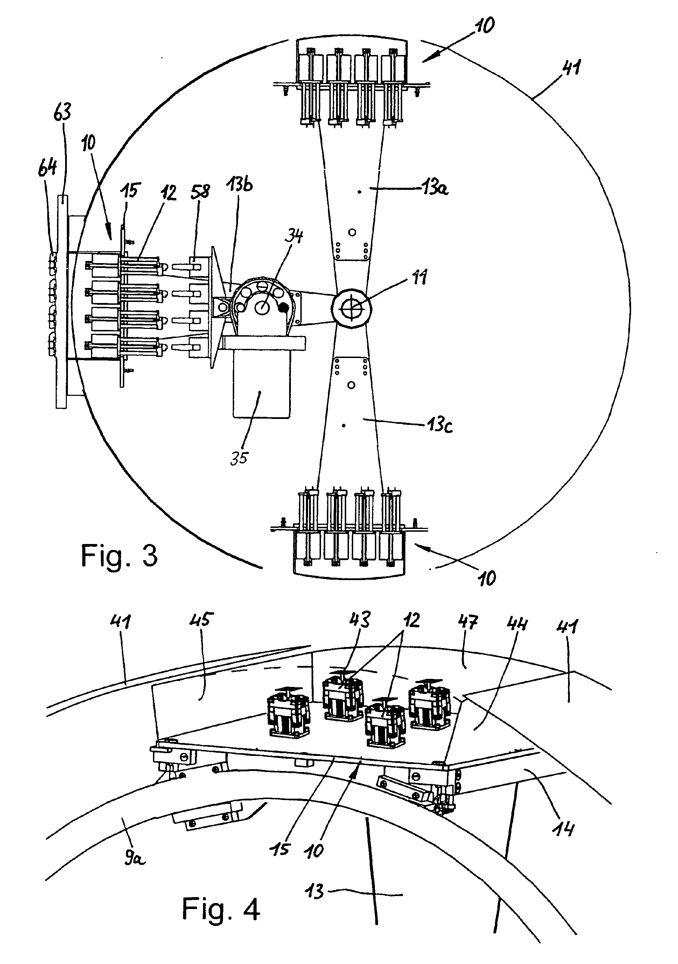

An jedem Umlaufwagen 10 sind mehrere identische Plunger 12 mit Vakuumsaugern befestigt, die jeweils zum Halten eines zu testenden elektronischen Bauelements 43, beispielsweise eines Halbleiterbauelements (IC), dienen. In den Figuren 3 bis 7 ist teilweise eine unterschiedliche Anzahl von Plungern 12 eingezeichnet, wobei das Ausführungsbeispiel gemäß den Figuren 3, 6, 7 von sechzehn Plungern 12 ausgeht, die in Form einer 4 x 4 Matrix angeordnet sind. Es ist jedoch ohne weiteres möglich an jedem der Umlaufwagen 10 eine andere Anzahl von Plungern 12 vorzusehen, um eine entsprechende Anzahl von Bauelementen gleichzeitig aufnehmen, zum Testkopf 5 transportieren und von diesem wieder entfernen zu können. Besonders zweckmäßig kann es dabei sein, die Plunger 12 matrixförmig auf den Umlaufwagen 10 anzuordnen, beispielsweise in Form einer 3 x 3, 2 x 4, 4 x 4 oder 5 x 5 Matrix.

Die Umlaufwagen 10 sind in den Figuren lediglich partiell dargestellt, um die Sicht auf dahinter liegende Teile freizugeben oder die Übersichtlichkeit zu erhöhen. Weiterhin sind in der schematischen Darstellung von Figur 1 nicht die Umlaufwagen 10 als solche, sondern lediglich zugeordnete Antriebsarme 13 (die einzelnen Antriebsarme sind mit 13a, 13b, 13c bezeichnet) dargestellt, die sich von der Mittelachse 11 aus radial nach außen zu jeweils einem Umlaufwagen 10 erstrecken und diesen in Umlaufrichtung antreiben.

Wie in Figur 2 angedeutet, weisen die Umlaufwagen 10 einen rechteckigen Rahmen 14 auf, auf dem eine zweigeteilte Bodenplatte 15 festgeschraubt ist. In Figur 2 sind die Umlaufwagen 10 nur mit einer Hälfte der Bodenplatte 15 dargestellt, um den Blick auf die dahinter liegenden Teile zu ermöglichen. Die Bodenplatte 15 dient insbesondere zum Befestigen der Plunger 12 und zur Abdichtung der Umlaufwagen 10 radial nach innen, um in dieser Richtung Wärmeverluste zu vermeiden, falls die Bauelemente 43 innerhalb der Umlaufwagen 10 temperiert werden.

Die lösbare Befestigung der Bodenplatte 15 auf dem Rahmen 14 bietet den Vorteil, dass die Bodenplatte 15 zusammen mit den Plungern 12 auf einfache Weise ausgetauscht werden kann, falls beispielsweise eine Anpassung an eine andere Umgebungsstruktur erforderlich wird.

Wie aus Figur 4 ersichtlich, weist jeder Umlaufwagen 10 ein Gehäuse 48 auf, das aus der Bodenplatte 15, einer vorderen Wand 44, einer hinteren Wand 45 sowie zwei Seitenwänden 46, 47 besteht. Die Wände 44-47 bilden zusammen mit der ebenen Bodenplatte 15 ein wannenartiges Gehäuse, das seitlich und radial nach innen zumindest im Wesentlichen geschlossen, radial nach außen jedoch, d.h. in Figur 4 nach oben, geöffnet ist. Derjenige Teil der Plunger 12, der in Figur 4 dargestellt ist, befindet sich vollständig innerhalb des Gehäuses 48. Mit Hilfe des Gehäuses 48 ist es möglich, jeden Umlaufwagen 10 als umlaufende Temperierkammer für die Bauelemente 43 auszubilden.

Damit beim Temperieren der Bauelemente 43 die Wärme nicht unkontrolliert radial nach außen aus den Umlaufwagen 10 abströmt, ist mit geringem radialen Abstand außerhalb der Umlaufwagen 10 eine umlaufende Abdeckung 51 in der Form eines stationären, ringförmigen Abdeckblechs angeordnet. Die Abdeckung 51 überdeckt die Umlaufwagen 10 über ihren gesamten Umlaufweg mit Ausnahme in denjenigen Bereichen, in denen die Umlaufwagen 10 mit Bauelementen 43 beladen, entladen und in Richtung zur Testvorrichtung radial nach außen geschoben werden. In Figur 4 ist die Beladestation gezeigt, in der die Abdeckbleche in Umlaufrichtung soweit voneinander beabstandet sind, dass die Bauelemente 43 behinderungsfrei auf die zugeordneten Plunger 12 aufgesetzt werden können.

Jeder Umlaufwagen 10 kann von einem eigenen Antriebsarm 13 längs der Führungen 9a, 9b in Umlauf versetzt werden.

Wie aus Figur 2 ersichtlich, wird jeder Antriebsarm 13a, 13b, 13c von einer eigenen Antriebseinrichtung angetrieben, um die Umlaufwagen 10, die am radial äußeren Ende eines zugeordneten Antriebsarms 13a, 13b, 13c befestigt sind, unabhängig voneinander bewegen zu können. Der Antriebsarm 13a wird von einem Antriebsmotor 18a über ein Antriebszahnrad 19a, ein zentrales Zahnrad 20a, einen Zahnriemen 21a oder eine zugeordnete Antriebswelle angetrieben. Der Antriebsarm 13b wird von einem Antriebsmotor 18b über ein Antriebszahnrad 19b, ein zentrales Zahnrad 20b, einen Zahnriemen 21b und eine zugeordnete Antriebswelle angetrieben. Der Antriebsarm 13c wird von einem Antriebsmotor 18c über ein Antriebszahnrad 19c, ein zentrales Zahnrad 20c, einen Zahnriemen 21c und eine zugeordnete Antriebswelle angetrieben. Die drei Antriebswellen sind konzentrisch ineinander um die gemeinsame horizontale Mittelachse 11 angeordnet, wobei zwei Antriebswellen um die innerste Antriebswelle herum drehbar sind.

Aufgrund dieser Anordnung ist es möglich, die Umlaufwagen 10 unabhängig voneinander ohne gegenseitige starre Kopplung um die Mittelachse 11 herum zu drehen, um verschiedene Positionen längs der Kreisbahn anzufahren. In den Figuren 2 und 3 ist jeweils ein Umlaufwagen 10 in der oberen Beladeposition, in der die zu testenden Bauelemente 43 auf die Plunger 12 aufgesetzt werden, in der seitlichen Testposition, in der die Bauelemente horizontal vorgeschoben und mit den zugeordneten Kontaktiervorrichtungen (Kontaktsockel) des Testkopfs 5 kontaktiert werden, und in der unteren Entladeposition dargestellt, in der die getesteten Bauelemente 43 von den Plungern 12 abgenommen werden. Zusätzlich können die Umlaufwagen 10 dazwischenliegende Positionen, beispielsweise Ausricht- und Wartepositionen anfahren, wobei sie schrittweise immer in der gleichen Drehrichtung in die jeweils nachfolgende Position bzw. Station weiter gedreht werden.

Um die zu testenden Bauelemente 43 in der seitlichen Position eines Umlaufwagens 10 (in Figur 3 die 9 Uhr Position) geradlinig und horizontal in Richtung des Testkopfs 5 vorzuschieben und mit Kontaktsockeln zu kontaktieren, die mit dem Testkopf 5 elektrisch verbunden sind, ist eine lediglich in den Figuren 3 und 5 bis 10 dargestellte Vorschubeinrichtung 30 vorgesehen. Diese Vorschubeinrichtung 30 ist, wie aus Figur 3 ersichtlich, im Bereich zwischen der Mittelachse 11 und den Plungern 12 angeordnet, die sich an demjenigen Umlaufwagen 10 befinden, der sich an der seitlichen Testposition befindet.

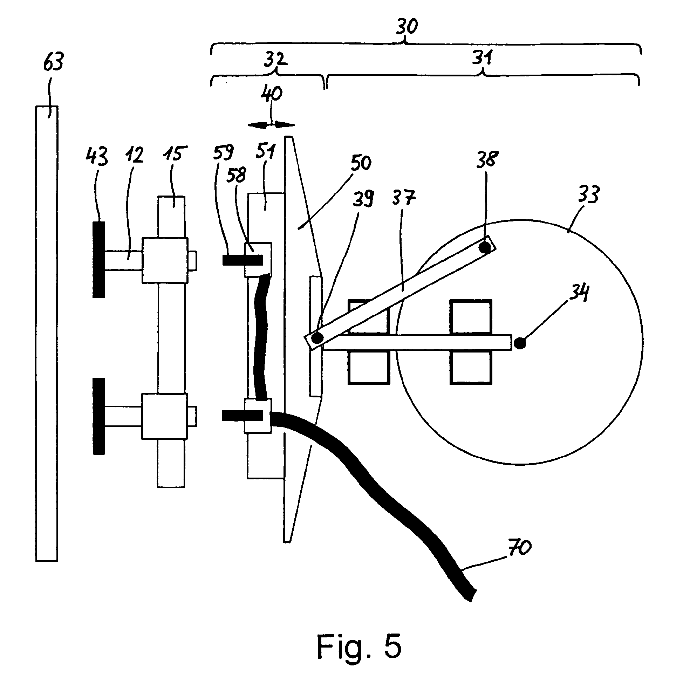

Wie aus der schematischen Darstellung von Figur 5 ersichtlich, weist die Vorschubeinrichtung 30 eine Pneumatikzylinderbewegungseinrichtung in der Form einer Kurbelwelleneinrichtung 31 und eine Pneumatikzylindereinrichtung 32 auf.

Die Kurbelwelleneinrichtung 31 umfasst eine als Riemenrad ausgebildete Kurbelwelle 33, die um eine parallel zur Mittelachse 11 angeordnete Drehachse 34 drehbar ist. Die Kurbelwelle 33 ist mittels einer Antriebseinrichtung 35 in Form eines Elektromotors in Umdrehung versetzbar, wobei der Elektromotor über einen Zahnriemen 36 mit der Kurbelwelle 33 drehgekoppelt ist.

Beidseits der Kurbelwelle ist jeweils eine Kurbelstange 37 angeordnet, wobei die beiden Kurbelstangen 37 mit ihrem einen Ende über einen Querbolzen 38 exzentrisch an der Kurbelwelle 33 gelagert sind.

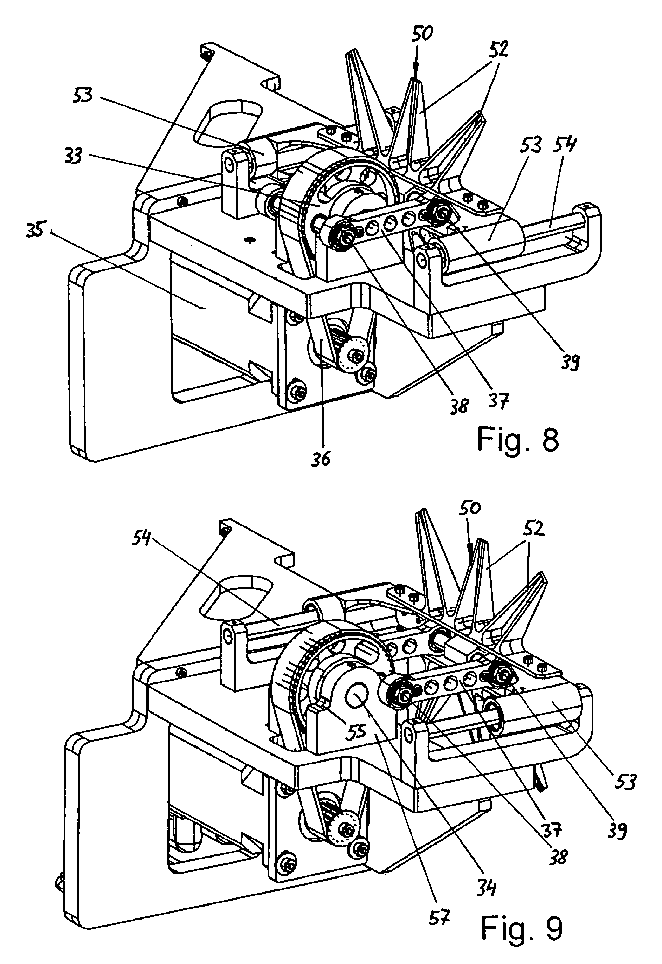

Die beiden Kurbelstangen 37 sind mit ihrem gegenüberliegenden Ende mittels eines Querbolzens 39 an der Plungerdrückeinrichtung 32 schwenkbar gelagert, um diese geradlinig horizontal, d.h. in Richtung des Pfeils 40 (Figur 5) zu verschieben, indem die Kurbelwelle 33 in Umdrehung versetzt wird. Die Pneumatikzylindereinrichtung 32 weist einen Plattenträger 50 und eine an diesem befestigte Halteplatte 51 auf. Der Plattenträger 50 umfasst ein Stützteil mit einzelnen Fingern 52, an denen die Zylinderhalteplatte 51 befestigt ist, sowie beidseits des Stützteils angeordnete Führungshülsen 53, mit denen der Plattenträger 50 verschiebbar an stationären Führungsstangen 54 (Figuren 8, 9) gelagert ist. Wird die Kurbelwelle 33 aus der in Figur 8 dargestellten Stellung, in der sich der Querbolzen 38 relativ zum Plattenträger 50 hinter der Drehachse 34 befindet, um etwa 180° in die in Figur 9 gezeigte Stellung gedreht, in der sich der Querbolzen 38 zwischen der Drehachse 34 und dem Plattenträger 50 befindet, wird somit der Plattenträger 50 über die beiden Kurbelstangen 37 geradlinig in die in Figur 9 gezeigte vordere Stellung geschoben. Wird aus dieser Stellung die Kurbelwelle 33 wieder in entgegengesetzter Richtung in die in Figur 8 gezeigte Ausgangsstellung zurückgedreht, wird der Plattenträger 50 in entsprechender Weise geradlinig zurückgezogen. Der Drehweg der Kurbelwelle 33 wird hierbei durch Schultern 55, 56 von Lagerkonsolen 57 begrenzt, an denen die Drehachse 34 gelagert ist, wobei der Querbolzen 38 in den Endpositionen an den Schultern 55, 56 anschlägt.

Die Zylinderhalteplatte 51 dient zum Befestigen einer Mehrzahl von Pneumatikzylindern 58, wobei jedem Plunger 12 ein Pneumatikzylinder 58 gegenüberliegt. Die Anzahl der Pneumatikzylinder 58 entspricht somit zweckmäßigerweise der Anzahl der Plunger 12.

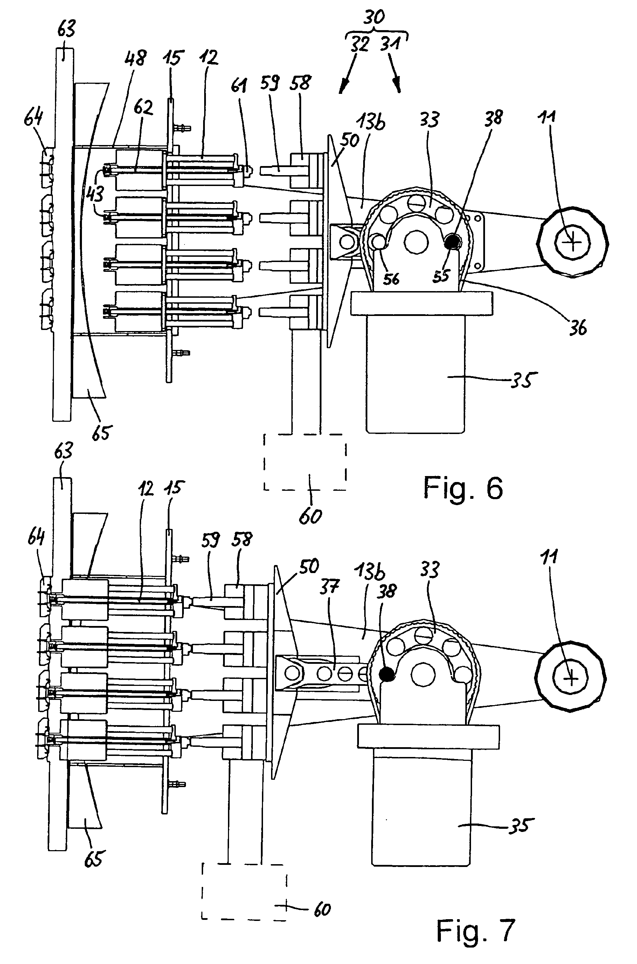

Die Pneumatikzylinder 58 weisen Kolbenstangen 59 auf, die fluchtend zu den Plungern 12 angeordnet und in Vorschubrichtung (Zustellrichtung) aus dem Pneumatikzylinder 58 ausfahrbar bzw. in diesen einfahrbar sind. Hierzu ist jeder Pneumatikzylinder 58, wie später noch anhand von Figur 12 näher beschrieben wird, über entsprechende Pneumatikleitungen mit einer Fluidversorgungseinrichtung 60 verbunden (siehe Figuren 6 und 7). Bei den Pneumatikzylindern 58 handelt es sich um Kurzhubzylinder.

Die Plunger 12 sind in ihrer Längsrichtung verschiebbar an der Bodenplatte 15 der Umlaufwagen 10 gehaltert. Hierzu weisen die Plunger 12 einen vorderen Abschnitt auf, der im zurückgezogenen Zustand der Plunger, der in Figur 6 dargestellt ist, innerhalb des Gehäuses 48 der Umlaufwagen 10 angeordnet ist, und einen hinteren Abschnitt, der nach hinten, d.h. innerhalb der Handhabungsvorrichtung 4 radial nach innen, über die Bodenplatte 15 hinausragt. In dieser zurückgezogenen Stellung der Plunger 12 werden die Umlaufwagen 10 in die seitliche Testposition gebracht, die in Figur 3 der 9 Uhr Position entspricht. In der zurückgezogenen Position sind die hinteren Enden der Plunger 12, wie aus den Figuren 3 und 6 ersichtlich, zu den vorderen Enden der Kolbenstangen 59 beabstandet und zu diesen vollkommen separiert, so dass die Umlaufwagen 10 in die Testposition gefahren werden können, ohne die Kolbenstangen 59 zu kontaktieren. In der Testposition liegen die Kolbenstangen 59 einem hinteren Ende 61 der Plunger 12 genau gegenüber (Figur 6). In dieser Position befinden sich die Bauelemente 43, die an der Spitze eines zentralen, rohrförmigen Saugers 62 der Plunger 12 festgesaugt sind, zurückgezogen innerhalb des Gehäuses 48 der Umlaufwagen 10, wobei auch das Gehäuse 48 einen geringen Abstand zu einem testerseitig angeordneten Kontaktsockelträger 63 aufweist, so dass der betreffende Umlaufwagen 10 in dem Bereich zwischen dem Kontaktsockelträger 63 und den Pneumatikzylindern 58 eingefahren werden kann. Der Kontaktsockelträger 63 trägt Kontaktsockel 64 mit Kontakten, mit denen die zu testenden Bauelemente 43 in Kontakt gebracht werden müssen. Weiterhin ist in den Figuren 6 und 7 noch eine Isolierung 65 schematisch dargestellt, welche ein unkontrolliertes Abströmen von Wärme aus dem Gehäuse 48 der Umlaufwagen 10 verhindert.

Um die Bauelemente 43 von ihrer in Figur 6 gezeigten zurückgezogenen Stellung in die in Figur 7 gezeigte vorgeschobene Kontaktposition vorzuschieben, wird die Kurbelwelle 33 um etwa 180° im Gegenuhrzeigersinn gedreht, wodurch die Pneumatikzylindereinrichtung 32 geradlinig in Richtung der Kontaktsockel 64 bewegt wird. Die Kolbenstange 59 der Pneumatikzylinder 58 drücken hierbei auf das hintere Ende 61 der Plunger 12 und schieben dadurch die Plunger 12 entsprechend nach vorne in die in Figur 7 gezeigte Kontaktstellung. Die Kolbenstangen 59 der Pneumatikzylinder 58 sind hierbei um ein vorbestimmtes Maß ausgefahren. Die Stellung der Kolbenstangen 59 relativ zu den Pneumatikzylindern 58 kann, solange kein Regeleingriff erforderlich ist, beibehalten werden. Es ist somit nicht erforderlich, die Kolbenstange 59 nach jedem Testvorgang einzufahren und vor jedem neuen Testvorgang wieder auszufahren. Die einzelnen Pneumatikzylinder 58 sind individuell ansteuerbar, so dass es auf diese Weise möglich ist, einzelne Pneumatikzylinder 58 zu aktivieren oder zu deaktivieren. Weiterhin gestatten die Pneumatikzylinder 58, Toleranzen bei der Kontaktierung auszugleichen. Weichen die Positionen der Kontaktsockeln oder der Bauelementkontakte in Zustellrichtung voneinander ab, werden die zugeordneten Kolbenstangen 59 automatisch mehr oder weniger weit zurückgedrückt, wobei der Anpressdruck im Wesentlichen gleich bleibt. Weiterhin ist es mit Hilfe der Pneumatikzylinder 58 möglich, eine gezielte Auswahl zwischen den zu kontaktierenden Kontaktsockeln 64 vorzunehmen, falls beispielsweise einige Kontaktsockel 64 nicht bedient werden sollen. In diesem Fall bleiben die betreffenden Kolbenstangen 59 eingefahren, so dass die betreffenden Plunger nicht bis in ihre Kontaktendstellung vorgeschoben werden.

Der normale Hubweg für die Zustellung der Plunger 12 von ihrer zurückgezogenen Position in ihre vordere Kontaktendposition erfolgt somit mechanisch über die Kurbelwelleneinrichtung 31, während die Pneumatikzylinder 58 lediglich zur Feinregulierung und damit für einen gleichmäßigen Anpressdruck aller Bauelemente 43 bzw. zur gezielten Auswahl einzelner Plunger 12 dienen.

Nach Beendigung des Testvorgangs wird die Kurbelwelle 33 wieder im Uhrzeigersinn in die in Figur 6 gezeigte Stellung zurückgedreht, wodurch die Pneumatikzylindereinrichtung 32 in ihre zurückgezogene Stellung zurückgefahren wird. Die Plunger 12 werden durch eine entsprechende, nicht dargestellte Rückholfeder, die an jedem Plunger 12 vorgesehen ist, in ihre zurückgezogene Stellung zurückgezogen, in der die Bauelemente 43 wieder innerhalb des Gehäuses 48 angeordnet sind und die Plunger 12 von den Kolbenstangen 59 der Pneumatikzylinder 58 getrennt sind. Der Umlaufwagen 10 kann damit aus der Teststation gefahren werden, so dass ein nachfolgender Umlaufwagen 10 mit noch nicht getesteten Bauelementen 43 in die Testposition gefahren werden kann.

Die Vorschub- bzw. Rückzuggeschwindigkeit der Vorschubeinrichtung 30 ändert sich aufgrund der Kurbelwelleneinrichtung 31 längs des Vorschubwegs in Abhängigkeit der Winkelposition, welche die Lagerstelle, d.h. der Querbolzen 38, der Kurbelstangen 37 an der Kurbelwelle 33 einnimmt. Wie aus Figur 5 abgeleitet werden kann, beträgt die Vorschubgeschwindigkeit in der 3 Uhr und 9 Uhr Stellung des Querbolzens 38, d.h. wenn die Verbindungslinie zwischen dem Querbolzen 38 und dem Querbolzen 39 parallel zur Vorschubrichtung ist, gleich Null, während die Vorschubgeschwindigkeit am höchsten ist, wenn sich der Querbolzen 38 in der 12 Uhr Position befindet. Durch die Verlangsamung der Vorschubgeschwindigkeit bei Annäherung des Querbolzens 38 an die 9 Uhr Position kann ein sanftes Aufsetzen der Bauelemente 43 auf die zugeordneten Kontaktsockel 64 erreicht werden.

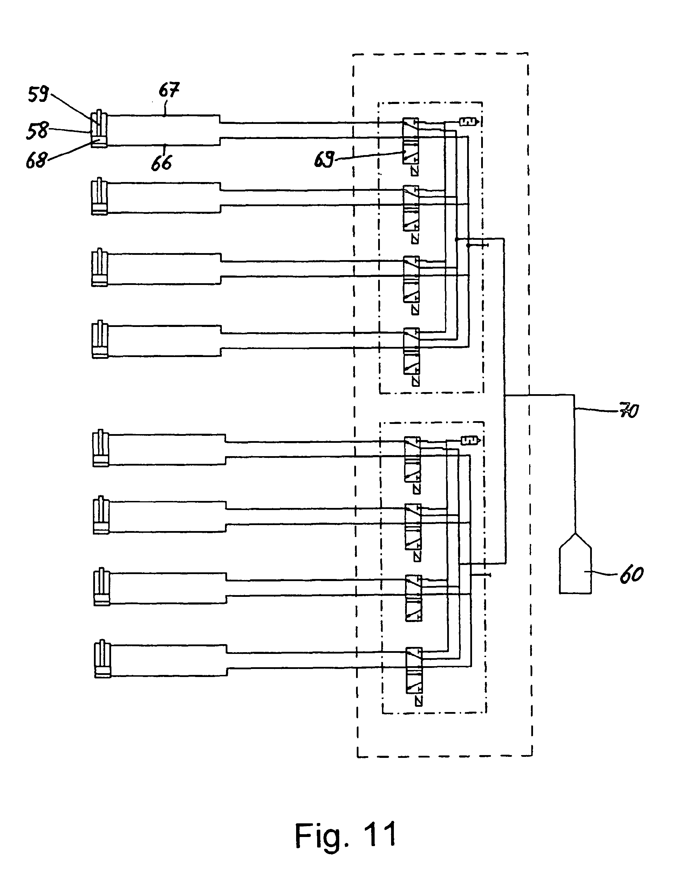

In Figur 11 ist ein Pneumatikschaltbild mit acht Pneumatikzylindern 58 dargestellt. Jeder Pneumatikzylinder 58 ist über eine Pneumatikleitung 66 und eine zweite Pneumatikleitung 67 mit der Fluidversorgungseinrichtung 60 verbunden. Die erste Pneumatikleitung 66 mündet unterhalb und die zweite Pneumatikleitung 67 oberhalb eines Kolbens 68 in den Pneumatikzylinder 58. Die Pneumatikleitungen 66, 67 sind über elektromagnetisch betätigbare Steuerventile 69 in der Form von 5/2-Wegeventilen derart mit einer zur Fluidversorgungseinrichtung 60 führenden Hauptversorgungsleitung 70 bzw. mit geeigneten Entlüftungsleitungen verbindbar, dass die Kolbenstangen 59 unabhängig voneinander aus den Pneumatikzylindern 58 ausgefahren, in diese eingefahren bzw. in einer bestimmten Stellung gehalten werden können.

Bei den ersten und zweiten Pneumatikleitungen 66, 67 handelt es sich um bewegliche Druckleitungen, während die Wegeventile 69 stationär in der Handhabungsvorrichtung 4 angeordnet sind.

## Patentansprüche

1. Handhabungsvorrichtung für elektronische Bauelemente, insbesondere IC's, mit:
- mindestens einer Transporteinheit zum Transportieren von zu testenden Bauelementen (43) in eine Position, in der sie Kontakteinrichtungen einer Testvorrichtung gegenüberliegen,
- auf der Transporteinheit angeordneten Plungern (12), an denen die Bauelemente (43) gehaltert und die in ihrer Axialrichtung bis in eine vordere Kontaktposition verschiebbar sind, in der die Bauelemente (43) mit den zugeordneten Kontaktiereinrichtungen in Kontakt sind,
- einer von der Transporteinheit getrennten Vorschubeinrichtung (30) zum Verschieben der Plunger (12), die eine Pneumatikzylindereinrichtung (32) mit Pneumatikzylindern (58) aufweist, die mit den Plungern (12) in Kontakt bringbar und von diesen trennbar sind,
**dadurch gekennzeichnet, dass** die Pneumatikzylindereinrichtung (32) verschiebbar ausgebildet und mit einer die Pneumatikzylindereinrichtung (32) in Axialrichtung der Plunger (12) hin- und herbewegenden Pneumatikzylinderbewegungseinrichtung gekoppelt ist.

2. Handhabungsvorrichtung nach Anspruch 1, **dadurch gekennzeichnet, dass** die Pneumatikzylinderbewegungseinrichtung aus einer Kurbelwelleneinrichtung (31) besteht, die eine Antriebseinrichtung (35), eine von der Antriebseinrichtung (35) in Umdrehung versetzbare Kurbelwelle (33) und mindestens eine exzentrisch an der Kurbelwelle (33) gelagerte Kurbelstange (37) aufweist, die mit der Pneumatikzylinderbewegungseinrichtung (32) gekoppelt ist, um diese in Axialrichtung der Plunger (12) zu verschieben.

3. Handhabungsvorrichtung nach Anspruch 1, **dadurch gekennzeichnet, dass** die Pneumatikzylinderbewegungseinrichtung aus einem Spindelantrieb besteht.

4. Handhabungsvorrichtung nach einem der Ansprüche 1 bis 3, **dadurch gekennzeichnet, dass** die Pneumatikzylindereinrichtung (32) einen Plattenträger (50) und eine an diesem befestigte Zylinderhalteplatte (51) aufweist, wobei der Plattenträger (50) verschiebbar an einer stationär innerhalb der Handhabungsvorrichtung (4) angeordneten Führungseinrichtung (9) geführt ist und die Pneumatikzylinder (58) an der Zylinderhalteplatte (51) befestigt sind.

5. Handhabungsvorrichtung nach einem der Ansprüche 1 bis 4, **dadurch gekennzeichnet, dass** jedem Plunger (12) einer Transporteinheit ein Pneumatikzylinder (58) zugeordnet ist.

6. Handhabungsvorrichtung nach einem der Ansprüche 1 bis 5, **dadurch gekennzeichnet, dass** für jeden Pneumatikzylinder (58) oder für einzelne Untergruppen von Pneumatikzylindern (58) ein Steuerventil (69) zum Öffnen bzw. Schließen zugeordneter Pneumatikleitungen (66, 67) vorgesehen ist, so dass jeder Pneumatikzylinder (58) oder Untergruppen von Pneumatikzylindern (58) individuell über die Steuerventile (69) aktivierbar sind und nur ausgewählte Plunger (12) in die vordere Kontaktposition überführbar sind.

7. Handhabungsvorrichtung nach einem der Ansprüche 1 bis 6, **dadurch gekennzeichnet, dass** die Pneumatikzylinder (58) als Kurzhubzylinder ausgebildet sind und Kolbenstangen (59) aufweisen, die durch Luftdruck nachgiebig einschiebbar im Zylindergehäuse gehalten sind, wobei die Kraft zum Einschieben der Kolbenstange (5) zumindest über einen anfänglichen Teil des Einschubwegs im Wesentlichen konstant bleibt.

## Claims

1. Handling device for electronic components, in particular ICs, comprising:
- at least one transport unit for transporting components (43) to be tested into a position in which they are opposite contacting means of a test device,
- plungers (12), which are arranged on the transport unit and on which the components (43) are mounted and which can be displaced in the axial direction thereof into a front contact position in which the components (43) are in contact with the associated contacting means,
- a feed means (30) for displacing the plungers (12), which is separate from the transport unit and comprises a pneumatic cylinder means (32) comprising pneumatic cylinders (58) which can be brought into contact with and separated from the plungers (12),
**characterised in that** the pneumatic cylinder means (32) is formed displaceably and is coupled to a pneumatic cylinder movement means which moves the pneumatic cylinder means (32) back and forth in the axial direction of the plungers (12).

2. Handling device according to claim 1, **characterised in that** the pneumatic cylinder movement means consists of a crankshaft means (31), which comprises a drive means (35), a crankshaft (33) which can be set in rotation by the drive means (35), and at least one connecting rod (37), which is eccentrically mounted on the crankshaft (33) and is coupled to the pneumatic cylinder movement means (32) to displace said means in the axial direction of the plungers (12).

3. Handling device according to claim 1, **characterised in that** the pneumatic cylinder movement means consists of a spindle drive.

4. Handling device according to any one of claims 1 to 3, **characterised in that** the pneumatic cylinder means (32) comprises a plate support (50) and a cylinder holding plate (51) which is fixed thereto, the plate support (50) being displaceably guided on a guide means (9) which is arranged in a stationary manner inside the handling device (4) and the pneumatic cylinders (58) being fixed to the cylinder holding plate (51).

5. Handling device according to any one of claims 1 to 4, **characterised in that** a pneumatic cylinder (58) is associated with each plunger (12) of a transport unit.

6. Handling device according to any one of claims 1 to 5, **characterised in that** for each pneumatic cylinder (58) or for individual sub-groups of pneumatic cylinders (58), a control valve (69) is provided for opening or closing associated pneumatic lines (66, 67), in such a way that each pneumatic cylinder (58) or sub-groups of pneumatic cylinders (58) can be activated individually by means of the control valves (69) and only selected plungers (12) can be transferred into the front contact position.

7. Handling device according to any one of claims 1 to 6, **characterised in that** the pneumatic cylinders (58) are formed as short-stroke cylinders and comprise piston rods (59) which are held in the cylinder housing by air pressure so as to be flexibly insertable, the force for inserting the piston rod (5) remaining substantially constant at least over an initial part of the insertion path.

## Revendications

1. Dispositif de manutention pour composants électroniques, en particulier des circuits intégrés, comprenant :
- au moins une unité de transport pour transporter des composants à tester (43) jusque dans une position dans laquelle ils sont à l'opposé de moyens de contact d'un dispositif de test,
- des plongeurs (12) agencés sur l'unité de transport, sur lesquels les composants (43) sont maintenus et qui sont déplaçables dans leur direction axiale jusque dans une position de contact avancée dans laquelle les composants (43) sont en contact avec les moyens de contact associés,
- un système de déplacement (30), séparé de l'unité de transport, pour déplacer les plongeurs (12), qui comprend un système à vérins pneumatiques (32) avec des vérins pneumatiques (58) qui peuvent être amenés en contact avec les plongeurs (12) et séparés de ceux-ci,
**caractérisé en ce que** le système à vérins pneumatiques (32) est réalisé déplaçable et est accouplé avec un système de déplacement de vérins pneumatiques qui déplace le système à vérins pneumatiques (32) en va-et-vient en direction axiale des plongeurs (12).

2. Dispositif de manutention selon la revendication 1, **caractérisé en ce que** le système de déplacement de vérins pneumatiques est constitué par un dispositif à vilebrequin (31) qui comprend un moyen d'entraînement (35), un vilebrequin (33) susceptible d'être mis en rotation par le moyen d'entraînement (35), et au moins une bielle (37) montée de façon excentrée sur le vilebrequin (33) et accouplée au système de déplacement de vérins pneumatiques (32) afin de déplacer celui-ci en direction axiale des plongeurs (12).

3. Dispositif de manutention selon la revendication 1, **caractérisé en ce que** le système de déplacement de vérins pneumatiques est constitué par un entraînement à broche.

4. Dispositif de manutention selon l'une des revendications 1 à 3, **caractérisé en ce que** le système à vérins pneumatiques (32) comprend un porte-plaque (50) et une plaque de maintien de vérins (51) fixée sur celui-ci, dans lequel le porte-plaque (50) est guidé en déplacement sur un moyen de guidage (9) agencé de façon stationnaire à l'intérieur du dispositif de manutention (4), et les vérins pneumatiques (58) sont fixés sur la plaque de maintien de vérin (51).

5. Dispositif de manutention selon l'une des revendications 1 à 4, **caractérisé en ce qu'**un vérin pneumatique (58) est associé à chaque plongeur (12) d'une unité de transport.

6. Dispositif de manutention selon l'une des revendications 1 à 5, **caractérisé en ce que** pour chaque vérin pneumatique (58) ou bien pour des sous-groupes individuels de vérins pneumatiques (58) il est prévu une valve de commande (69) pour ouvrir ou fermer des conduites pneumatiques associées (66, 67), de sorte que chaque vérin pneumatique (58) ou sous-groupe de vérins pneumatiques (58) peut être activé individuellement via les valves de commande (69) et uniquement des plongeurs choisis (12) peuvent être amenés dans la position de contact avancée.

7. Dispositif de manutention selon l'une des revendications 1 à 6, **caractérisé en ce que** les vérins pneumatiques (58) sont réalisés sous forme de vérins à faible course et comprennent des tiges de piston (59) qui sont maintenues au moyen d'air comprimé de manière à pouvoir s'enfiler dans le boîtier de vérin tout en fléchissant, et la force pour enfiler la tige de piston (5) reste essentiellement constante au moins sur une partie initiale de la course d'enfilement.
